Europäisches Patentamt

European Patent Office

Office européen des brevets

(19)

(11) Publication number : **0 554 062 A1**

(12) **EUROPEAN PATENT APPLICATION**

(21) Application number : **93300571.2**

(22) Date of filing : **27.01.93**

(51) Int. Cl.$^5$: **G02F 1/136, H01L 27/12**

(30) Priority : **31.01.92 JP 40452/92**

(43) Date of publication of application :
**04.08.93 Bulletin 93/31**

(84) Designated Contracting States :
**DE FR GB**

(71) Applicant : **CANON KABUSHIKI KAISHA**
**30-2, 3-chome, Shimomaruko, Ohta-ku**
**Tokyo (JP)**

(72) Inventor : **Kochi, Tetsunobu, c/o Canon**
**Kabushiki Kaisha**
**3-30-2, Shimomaruko, Ohta-ku**
**Tokyo (JP)**

Inventor : **Miyawaki, Mamoru, c/o Canon**
**Kabushiki Kaisha**
**3-30-2, Shimomaruko, Ohta-ku**
**Tokyo (JP)**
Inventor : **Furushima, Teruhiko, c/o Canon**
**Kabushiki Kaisha**
**3-30-2, Shimomaruko, Ohta-ku**
**Tokyo (JP)**
Inventor : **Genchi, Yutaka, c/o Canon**
**Kabushiki Kaisha**
**3-30-2, Shimomaruko, Ohta-ku**
**Tokyo (JP)**

(74) Representative : **Beresford, Keith Denis Lewis**
**et al**
**BERESFORD & Co. 2-5 Warwick Court High**
**Holborn**
**London WC1R 5DJ (GB)**

(54) **Method of manufacturing transistor bases and liquid-crystal cells provided with same.**

(57) A method of manufacturing transistor bases includes the steps of : preparing a transistor base including an electroconductive base formed of a conductor or semiconductor, transistors formed on the electroconductive base with an insulating film provided therebetween, and electrodes which are electrically connected to the transistors, electrically connecting the electroconductive base to the electrodes, supplying electrostatic charge to the transistor base with the electrodes connected, and disconnecting the electrodes. This method prevents damage from occurring due to the application of electrostatic charge.

FIG. 3

GROUNDED AT PREDETERMINED ELECTRICAL POTENTIAL

EP 0 554 062 A1

## BACKGROUND OF THE INVENTION

### Field of the Invention

The present invention relates to a method of manufacturing bases for supporting a plurality of transistors, in particular, transistor bases having provided thereon thin film transistors (TFTs) in which thin-film single crystal Si is formed by SOI (Silicon On Insulator) technology and which are used as semiconductor devices, and to a method of manufacturing active matrix-type liquid-crystal display devices which are made practical using these transistor bases.

### Description of the Related Art

It is well known that transistors in which amorphous silicon (a-Si) or polycrystal silicon (poly-Si) is formed into thin-film semiconductors can be formed on a glass board as a base, and an active matrix-type liquid-crystal display device in which this transistor base is used can be manufactured. Typical examples of patents disclosing this structure are United States Patent Nos. 3,840,695, 4,470,667, and 4,568,149.

However, since the thin-film semiconductor on such a conventional transistor base is formed from a-Si or poly-Si, the responsiveness, number of pixels, resolution or the like thereof are limited.

Therefore, there has been a need for transistors for use in active matrix-type liquid-crystal display devices using thin-film single crystals instead of a-Si or poly-Si.

### SUMMARY OF THE INVENTION

A first object of the present invention is to provide transistor bases for use in active matrix-type liquid-crystal display devices whose responsiveness, number of pixels and resolution are improved over the prior art.

A second object of the present invention is to provide transistor bases in which thin-film single crystal silicon is used.

According to one aspect of the present invention which achieves these and other objects, there is provided a method of manufacturing transistor bases, comprising the steps of: preparing a transistor base comprising an electroconductive base formed of a conductor or semiconductor, a plurality of transistors arranged along a plurality of rows and columns of the electroconductive base with an insulating film provided therebetween, and a common electrode to which a plurality of corresponding transistors are electrically connected and which is connected to a common terminal, electrically connecting the electroconductive base to the common electrode, supplying static electricity to the transistor base with the common electrode connected, and disconnecting the common electrode.

According to another aspect of the present invention which achieves these and other objects, there is provided a method of manufacturing liquid-crystal cells, comprising the steps of arranging a second base to face and be spaced from the first base and injecting a liquid crystal between the first and second bases.

Objectives and advantages in addition to those discussed above will be apparent to those skilled in the art from the description of the preferred embodiments of the invention which follow. In the description, reference is made to the accompanying drawings, which form a part hereof, and which illustrate examples of the invention. Such examples, however, are not exhaustive of the various embodiments of the invention, and therefore reference is made to the appended claims for determining the scope of the invention.

### BRIEF DESCRIPTION OF THE DRAWINGS

Fig. 1 is a sectional view of a liquid-crystal display device in accordance with the present invention;

Fig. 2 is an illustration of an equivalent circuit of a matrix section of the display device of Fig. 1;

Fig. 3 is an illustration showing the principal manufacturing step of the present invention;

Figs. 4(a) and (b) illustrate an insulating layer etched to short-circuit with a common electrode to be grounded at the same electrical potential;

Fig. 5 illustrates an embodiment in which a lamination base is used;

Figs. 6(a) and (b) illustrate an embodiment during rubbing and after dicing;

Figs. 7(a) and (b) is an illustration in which a common electrode is short-circuited to a base in a cutout area; and

Fig. 8 is an illustration of an essential portion of a device having a light-shielding layer.

### DETAILED DESCRIPTION OF THE PREFERRED EMBODIMENTS

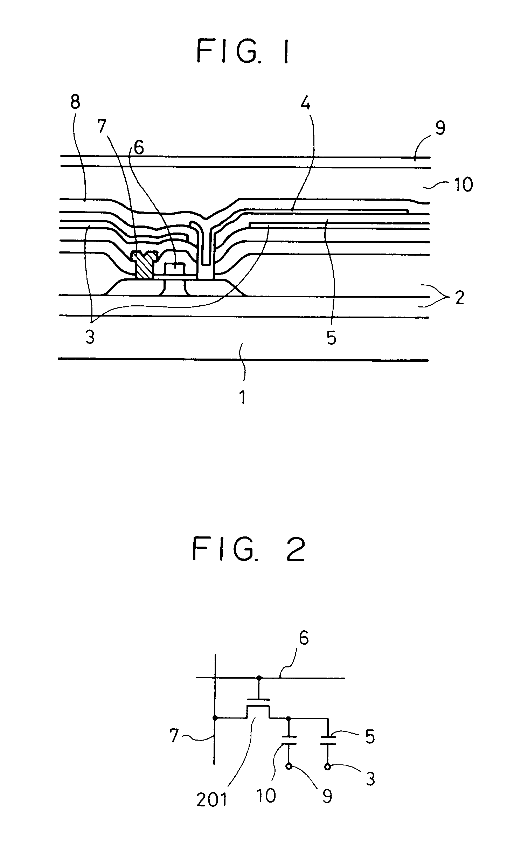

Electro-optical devices using a liquid crystal have been developed for thin, light-weight displays. Fig. 1 shows a schematic sectional view of a pixel of the improved device according to the present invention. Fig. 2 shows an equivalent circuit diagram thereof. Reference numeral 1 denotes an electroconductive base formed of a conductor or semiconductor formed from a single crystal silicon wafer or the like; reference numeral 2 denotes an insulating film formed from $SiO_2$ or the like; reference numeral 3 denotes a common electrode formed of a transparent electroconductive film formed from ITO; reference numeral 4 denotes a pixel electrode, a storage capacitance 5 being formed between the common electrode 3 and the pixel electrode 4; reference numeral 6 denotes a gate wire connected to the gate of a thin film transistor (TFT) 201; reference numeral 7 denotes a source line connected to the source of the TFT; reference numeral 8 denotes a protective film formed from silicon nitride or the like on the pixel electrode 4; reference numeral 9 denotes a facing electrode, formed from a transparent electroconductive film formed from ITO or the like, provided on a base (not illustrated) facing base 1, a liquid crystal being sealed between the protective film 8 and the facing electrode 9 to form a liquid-crystal capacitance 10, where a switch is formed of TFT 201.

When a signal voltage is applied to the source line 7 at a predetermined timing and when a gate drive voltage is applied to the gate line 6 at a predetermined timing, the TFT conducts between the source and the drain. The signal voltage is written in the liquid-crystal capacitance 10 formed between the facing electrode 9 and the pixel electrode 4. The transmittance of the sealed liquid crystal changes in proportion to the written voltage, thereby operating as a liquid-crystal display. When a display cell is made using a liquid-crystal display in this manner, it is important that liquid-crystal molecules within the cell be oriented in an orderly fashion. A method which has been widely used that easily orients the liquid-crystal molecules in a fixed direction parallel to the base provides that the surface of the protective film 8 is rubbed with a cloth in a fixed direction so that irregularities in the form of grooves are formed.

However, static electricity is generated on the surface of the protective film 8 by friction which occurs when the base is rubbed with a cloth. This static electricity causes a high-intensity electric field during the rubbing to be applied to devices (e.g., MOS transistors) within the board. This electric field causes an electrical charge to be injected into the MOS gate oxide film, and a dielectric breakdown of the gate oxide film occurs. In a concrete preferred embodiment of the present invention, the above-described risk is reduced. In addition, the present invention reduces the risk that the threshold voltage of the MOS will shift because of the injection of electrical charge and that the device will not operate at all because of the gate breakdown.

In the present invention, the application of an electrical potential as discussed below is effective to avoid damage during dicing and cleaning, in addition to during the above-mentioned rubbing. More specifically, during dicing when the base is cut to sections, static electricity which occurs when the base is rubbed can damage the devices therein. Also, during cleaning, high purity water is used, which is a non-conductor, and there is a possibility that the same kind of damage as above may be caused during ultrasonic wave cleaning using pure water. The damage during dicing and cleaning can be reduced by the shielding effect of the present invention.

The difference between the electrical potentials applied to the top electrode of the transistor and the bottom base is preferably in a range of 0 to several tens of +V, but is not limited to this range. The applied electrical potentials are preferably fixed values, but are not limited to these values.

Furthermore, since the electric fields actually applied to the transistors, as opposed to the fields applied to the electrodes leading to the transistors, are different depending upon the thickness, dielectric constant, resistivity or the like of the film provided between the electrodes and the transistors, the electrical potential to be applied must be controlled according to the construction of the transistor.

Fig. 1 is a sectional view of a liquid-crystal display device of the present invention.

The liquid-crystal display device of the present invention prevents direct current from flowing through the liquid-crystal display section by coating one of the electrodes which form the liquid-crystal display section with an insulating film so as to give it a capacitor effect. In the figure, the protective film 8 functions as the insulating film for the above purpose. It is formed, for example, from an inorganic material, such as SiO, $SiO_2$, TiO, $TiO_2$, $MgF_2$, or SiN, or from an organic material, such as PVA or Teflon.

Although generally a liquid-crystal display device has advantages, for example, the capability of being driven at low voltage and displaying at low power, it must be driven by an alternating voltage, because the service life thereof is short when driven by direct current. This is due to the well-known fact that when direct current is made to flow through a liquid-crystal portion, cations and anions within the liquid crystal adsorb onto the electrodes. Since the adsorbed substances disturb the orientation of grooves on the electrodes, the orientation of the liquid-crystal substance is disturbed, causing a defective external appearance. Also, when ionic substances adsorb onto electrodes, an electro-chemical reaction takes place on the surfaces of the electrodes, causing the release of oxygen, hydrogen or the like, and thus air and gas bubbles are generated. As a result, the exterior may be damaged considerably. Therefore, to increase the reliability of the liquid-crystal display device, it must be driven by an alternating voltage, and the application of direct-current voltage between the upper and lower electrodes must be prevented as much as possible. However, when the power-supply voltage of the circuit for driving the liquid-crystal display device is decreased (for example, when the voltage of the power-supply battery is decreased), the transistors of the circuit will malfunction. As a result, when driving by other than an alternating current is performed, or when an alternating current imbalance occurs even during alternating current driving due to variations of the ON resistance of the driving transistors or the like, a direct-current voltage is inevitably applied to the liquid-crystal display device, resulting in the deterioration thereof. This problem is solved by providing the liquid-crystal display device of the present invention with an insulating film, such as described above.

In the liquid-crystal display device of the present invention, moreover, the influence upon the liquid-crystal molecules of the electrical potential between the source line 7 and the pixel electrode 4 can be eliminated by orientating the liquid-crystal molecules on the base parallel to or substantially parallel to the direction of the gate line 6. This makes it possible to provide an image having a uniform contrast ratio over the entire screen.

In accordance with this concept, an organic high-polymer film can be formed on the base by a spin coat, roll coat or dip coat method or the like. This film is subjected to a rubbing operation to make it an orientation derivative layer. The rubbing operation is performed along the gate line 6 so that the liquid-crystal molecules are oriented parallel to it on the interface of the base. The oriented derivative layer is not limited to an organic high-polymer film, but also a film formed by obliquely vapor-depositing a metallic oxide may be used therefor. Even if a film other than the organic high-polymer film is used, it can be oriented as desired by using only the rubbing operation.

In the liquid-crystal display device, an oriented film is applied on the inner side of an area surrounded by a sealing agent. Therefore, the contact strength of the sealed portion is increased remarkably, and this solves the problem that the sealed portion of the panel may break down during liquid-crystal vacuum injection. If a thin rubbing cloth having a fiber thickness of 0.1 to 15 μm is used when the orientation operation is performed on the liquid crystal by rubbing, the rubbing is performed uniformly over the entire surface of the base, and orientation defects are rare. A uniformly-inclined orientation can thus be easily obtained over the entire surface in the STN or SBE mode.

Example 1

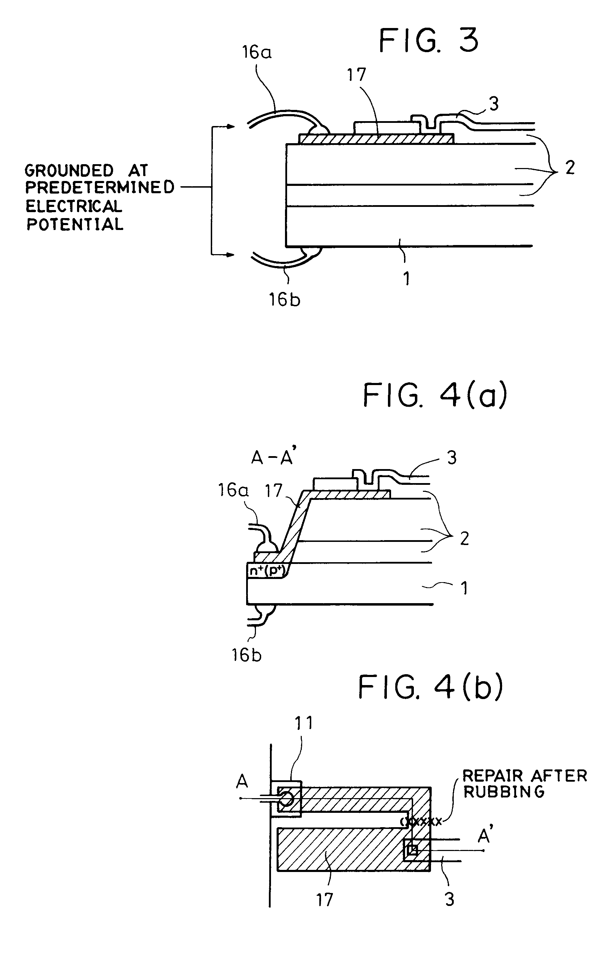

Fig. 3 is a sectional view of an end portion of a chip according to Example 1, illustrating a case in which a predetermined voltage is applied by grounding members 16a and 16b in relation to the electrical potentials of the common electrode 3 and the electroconductive base 1 during rubbing.

As shown in Fig. 1, the electroconductive base 1 formed from a silicon wafer is arranged on the bottom surface of a TFT 201 within the liquid-crystal display device of the present invention, and the common electrode 3 is arranged on the top surface thereof. In accordance with the present invention, damage during rubbing can be reduced by applying a predetermined voltage to the base 1 and the common electrode 3 during rubbing. The common electrode 3 is connected to a flexible leader terminal 17 in the end portion of the chip. During rubbing, the electrode 3 is made to protrude from the flexible leader terminal 17 and the surface of the electroconductive base 1.

Changes in the characteristics of the devices within the base can be reduced by applying a predetermined electrical potential to the grounding members 16a, 16b during rubbing. When rubbing was performed in which both grounding members 16a, 16b were grounded to the same electrical potential, excellent device characteristics having no threshold-value variations in the MOS devices could be obtained after rubbing. Needless to say, the same effect can be also obtained during dicing and cleaning in the present invention.

Example 2

Fig. 4 is a sectional view and top plan view of the end portion of a chip according to Example 2, illustrating a case in which the insulating film 2 is etched to short-circuit with the flexible leader terminal 17 so that both are grounded at the same electrical potential.

The electrode protrudes from the grounding member 16a or 16b from either the leader terminal 17 or the electroconductive base 1, and a predetermined electrical potential is applied thereto during rubbing so that damage to the device is reduced. There is an advantage in that only a single leader terminal is required during rubbing as opposed to Example 1.

After the rubbing operation, the common electrode 3 is cut off from the base 1 by a repair operation in order to separately apply an electrical potential, suited to drive the liquid-crystal display device, to the common electrode 3 and the electroconductive base 1.

Example 3

The method described below is a wafer technology suited to produce SOIs (Silicon On Insulators) configured to realize the liquid-crystal display device explained in the present invention. The single crystal Si layer of the semiconductor base is formed by using a porous Si base produced by making a single crystal Si base porous.

Observation of the porous Si base with a transmission type electron microscope has shown holes having a diameter of an average of approximately 600 Å in the porous Si base. The single crystallinity thereof is maintained in spite of the fact that the density thereof is one half or smaller than that of single crystal Si. It is possible to epitaxially grow the single crystal Si layer toward the upper portion of the porous layer. However, the holes therein are reoriented at temperatures above 1,000°C, and accelerating etching characteristics deteriorate. For this reason, low-temperature growth by a molecular beam epitaxial growth method, plasma CVD method, thermal CVD method, optical CVD method, bias sputtering method, liquid-crystal growth method, or the like is preferred for the epitaxial growth of the Si layer.

An explanation will now be given of a method of epitaxially growing single crystal layers after P-type Si is made porous.

First, an Si single crystal base is prepared. It is made porous by an anodization method using an HF solution. The density of the single crystal Si is 2.33 g/cm$^3$, but the density of the porous Si base can be changed to 0.6 to 1.1 g/cm$^3$ by changing the density of the HF to 20 to 50 wt%. This porous base can be easily formed into a P-type Si base due to the below-described reasons.

Porous Si was discovered in the course of researching electrolytical polishing of semiconductors. Positive holes are required for an Si anode reaction in the HF solution in the dissolution reaction of Si during anodization. The reaction is expressed as follows:

$$Si + 2HF + (2\text{-}n)\, e^+ \rightarrow SiF_2 + 2H^+ + ne^-$$
$$SiF_2 + 2H \rightarrow SiF_4 + H_2$$
$$SiF_4 + 2HF \rightarrow H_2SiF_6,$$

or

$$Si + 4HF + (4 - \lambda)\, e^+ \rightarrow SiF_4 + 4H^+ + \lambda e^-$$
$$SiF_4 + 2HF \rightarrow H_2SiF_6$$

where $e^+$ and $e^-$ represent positive holes and electrons respectively, and $n$ and $\lambda$ each represent, for the respective reactions, the number of positive holes required to dissolve one atom of Si. It is assumed that porous Si is formed when the conditions $n > 2$ or $\lambda > 4$ are satisfied. P-type Si having positive holes can be easily made porous for the above reasons.

It has been reported that high-density N-type Si can also be made porous. Therefore, Si can be made porous irrespective of whether it is P-type or N-type.

Since a large number of voids are formed within a porous layer, the density thereof decreases to half that of before. As a result, since the surface area is remarkably increased compared to the volume thereof, the chemical etching speed is accelerated to be considerably more than the conventional etching speed of a single crystal layer.

The conditions for making single crystal Si porous by anodization are shown below. Starting materials for porous Si formed by anodization are not limited to single crystal Si, but Si having other crystal structures may be used.

Applied voltage: 2.6 V

Current density: 30 mA·cm$^{-2}$

Anodization solution: HF : H$_2$O : C$_2$H$_5$OH = 1:1:1

Time: 2.4 hours

Thickness of porous Si: 300 μm

Porosity: 56%

Si is epitaxially grown on an Si base which has been made porous in the above-described way so that a thin film of single crystal Si is formed. The thickness of the Si base is preferably less than 50 μm and, more preferably, less than 20 μm.

After the surface of the thin film of the single crystal Si base is oxidized, a substrate which finally forms the base is prepared. The oxidized film on the surface of the single crystal Si is laminated on the base or, after the surface of a newly prepared single crystal Si is oxidized, it is laminated on the single crystal Si layer on the porous Si base. The reason why this oxide film is provided between the base and the single crystal Si is that since the level of the oxide film interface can be made lower than that of the glass interface regarding the interface level generated by the base interface of the Si active layer when, for example, glass is used as a base, characteristics of electronic devices can be enhanced remarkably. Only the single crystal Si thin film in which the porous Si base is etched and removed by selective etching, to be described below, may be laminated with a new base. The lamination is performed in such a way that the film and the base contact each other at room temperature after respective surfaces are cleaned, and the contact is sufficiently close so that the film and the base cannot be easily peeled off by van der Waals binding. This structure is heat treated in an atmosphere of nitrogen at temperatures of 200 to 900°C and preferably 600 to 900°C so that the film and the base are completely laminated.

An Si$_3$N$_4$ layer is deposited as an etch-preventing film on the entirety of the two laminated bases. Only the Si$_3$N$_4$ layer on the surface of the porous Si base is removed. Abietic wax may be used in place of the Si$_3$N$_4$ layer. Thereafter, all the porous Si base is removed by a process, such as etching. Thus, a semiconductor base having a thin-film single crystal Si layer can be obtained.

A method of selectively electrolessly wet-etching only the porous Si base will now be explained.

Preferred examples of etching solutions which do not etch crystal Si, but are capable of selectively etching only porous Si are: hydrofluoric acid, buffered hy-drofluoric acid, such as ammonium fluoride (NH$_4$F) or hydrogen fluoride (HF), a mixed solution of hydrofluo-ric acid or buffered hydrofluoric acid, to which alcohol is added, and a mixed solution of hydrofluoric acid or buffered hydrofluoric acid, to which hydrogen peroxide water and alcohol are added. The laminated bases are wetted with these solutions and etched. The etching speed depends upon the density and temperature of hydrofluoric acid, buffered hydrofluo-ric acid and hydrogen peroxide. The addition of hydrogen peroxide makes it possible to accelerate the oxidation of Si and to accelerate the reaction more than when it is not added. Furthermore, by varying the ratio of hydrogen peroxide, the reaction speed can be controlled. In addition, the addition of alcohol permits air bubbles, gas generated from the reaction by etching, to be removed instantly from the surface on which etching is performed without stirring. Thus, the porous Si can be etched uniformly and efficiently.

Based on the etching solution, the density of HF in the buffered hydrofluoric acid should be set in a range from 1 to 95 wt%, preferably 1 to 85 wt%, and more preferably 1 to 70 wt%. Based on the etching solution, the density of $NF_4F$ in the buffered hydrofluoric acid should be set in a range from 1 to 95 wt%, preferably 5 to 90 wt%, and more preferably 5 to 80 wt%. Based on the etching solution, HF density should be set in a range from 1 to 95 wt%, preferably 5 to 90 wt%, and more preferably 5 to 80 wt%.

Based on the etching solution, the $H_2O_2$ density should be set in a range from 1 to 95 wt%, preferably 5 to 90 wt%, and more preferably 10 to 80 wt%, and in a range in which the effect of the hydrogen peroxide water can be realized. Based on the etching solution, alcohol density should be set in a range from 80 wt%, preferably less than 60 wt%, and more preferably less than 40 wt%, and in a range in which the effect of alcohol can be realized.

The temperature should be 0 to 100°C, preferably 5 to 80°C, and more preferably 6 to 60°C.

Ether alcohol or isopropyl alcohol from which the above-described effect of the addition of alcohol can be realized may be used in the manufacturing process or the like.

Single crystal Si layers equivalent to ordinary Si wafers are formed in a large portion of the entire area of the semiconductor substrate and are obtained in this way in such a manner that they are formed into flat, uniform thin films.

The single crystal Si layer on the semiconductor substrate is separated by a partial oxidation method or formed into islands by etching. Afterwards, an impurity is doped to form a p- or n-channel transistor.

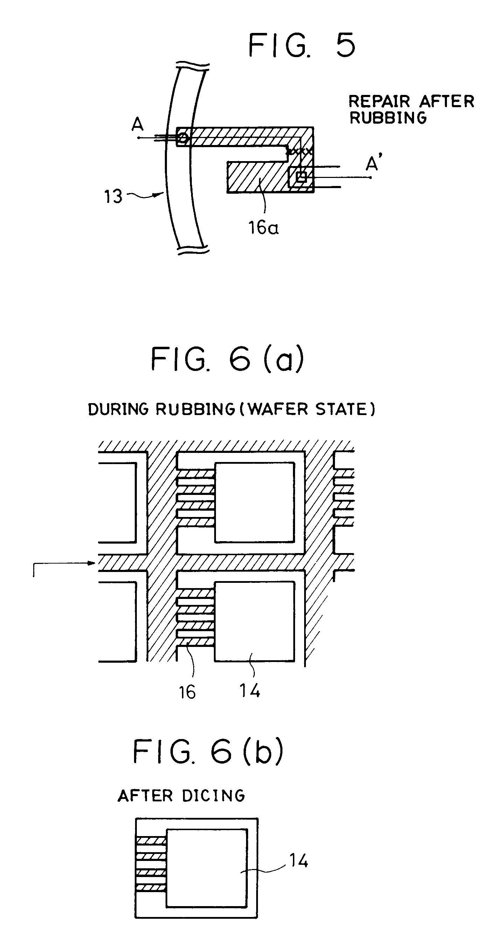

In the case of such laminated bases, the end portions peel off because they are rounded, and the base is exposed. Therefore, if the electrode 9 for fixing the electrical potential during rubbing as shown in Fig. 5 is extended to a board exposed area 13, the leader terminal 17 of the common electrode is short-circuited with the electroconductive base 1 in the board exposed area 13 without actively etching the insulating layer. Thus, the number of leader terminals during rubbing can be reduced to one. After rubbing, the common electrode 3 is cut off from the electroconductive base 1 by a repair operation in the same manner as in Example 2.

Example 4

Voltage application electrodes are provided at the wafer level in this example as opposed to the above example in which an voltage applied electrode is provided for each chip.

As shown in Fig. 6(a), a plurality of liquid-crystal display devices are arranged within the wafer. The leader terminals 17 of the display devices are patterned so as to connect to each other within the chip and between the chips A predetermined voltage is applied in the end of the wafer during rubbing. In this example, the number of leader terminals required during rubbing can be reduced to one even for a plurality of chips. After rubbing, the electrodes are separated from each other by dicing (Fig. 6(b)).

Example 5

When a light transmission type liquid crystal is used in the present invention, the transistor base must be transparent. For example, the pixel portion is made transparent (cut out) by etching using an etching solution, such as KOH.

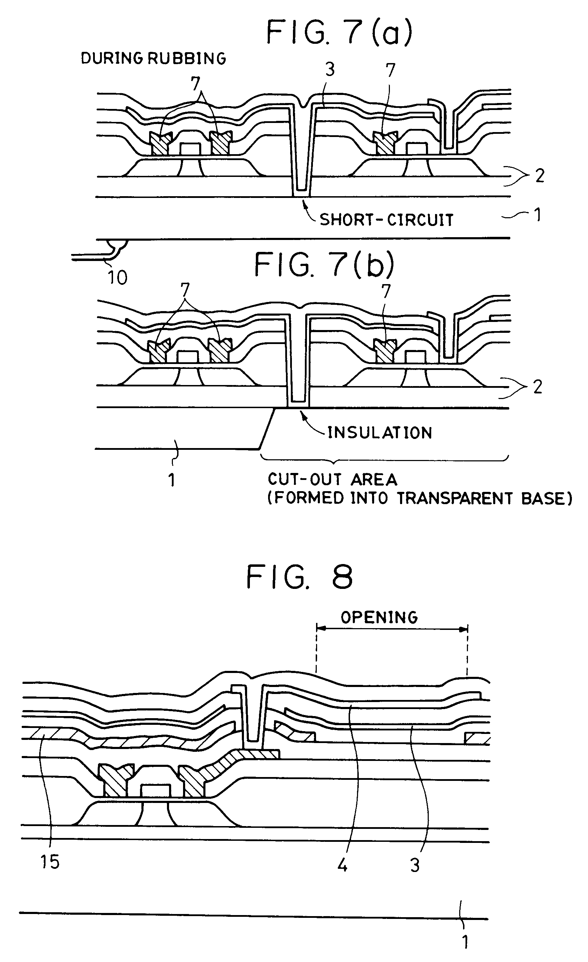

This example uses the above cut-out step. Fig. 7 shows a schematic sectional view thereof. As shown in Fig. 7(a), patterning is performed so that the common electrode 3 is short-circuited with the electroconductive base 1 within the electroconductive base 1. A predetermined voltage is applied to either the electroconductive base 1 or the leader terminal 17 of the common electrode during rubbing so that the electroconductive base 1 and the common electrode 3 are grounded at the same electrical potential and damage to the devices is reduced. After rubbing, the electroconductive base 1 and the common electrode 3 are cut off from each other simultaneously during the cut-out step as shown in Fig.7(b).

This example has an advantage in that the electroconductive base 1 and the common electrode 3 need not be cut off from each other in another step, such as a repair step, in contrast to Examples 2 and 3.

Example 6

Fig. 8 illustrates a light shielding metallic layer 15 used to shield electric fields of the top surface of the transistor in place of the common electrode 3. The electrical potential of the light shielding layer can be taken out in the same manner as Examples 1 to 5.

Needless to say, the same effect as in the previously-described examples can be obtained during dicing and cleaning in this example.

According to the present invention, transistors can be shielded from high-intensity electric fields applied thereto by applying a predetermined electrical potential to electrodes on the top and bottom surfaces of the transistors during rubbing or the like, thereby reducing damage.

Many different embodiments of the present invention may be constructed without departing from the spirit and scope of the present invention. It should be understood that the present invention is not limited to the specific embodiment described in this specification. To the contrary, the present invention is intended to cover various modifications and equivalent arrangements included within the spirit and scope of the claims. The following claims are to be accorded the broadest interpretation, so as to encompass all such modifications and equivalent structures and functions.

**Claims**

1. A method of manufacturing transistor bases, comprising the steps of:

   preparing a transistor base comprising an electroconductive base formed of a conductor or semiconductor, a plurality of transistors formed on the electroconductive base with an insulating film provided therebetween, and a plurality of electrodes which are electrically connected to respective ones of the transistors;

   electrically connecting the electroconductive base to the electrodes;

   supplying electrostatic charge to the transistor base with the electrodes so connected; and

   disconnecting the electrodes from the electroconductive base.

2. A method of manufacturing transistor bases, comprising the steps of:

   preparing a transistor base comprising: an electroconductive base formed of a conductor or semiconductor; a plurality of transistors arranged along a plurality of rows and columns on the electroconductive base with an insulating film provided therebetween; and a common electrode to which the plurality of corresponding transistors are electrically connected and which is connected to a common terminal;

   electrically connecting the electroconductive base to the common electrode;

   supplying static electricity to the transistor base with the common electrode connected; and

   disconnecting the common electrode from the electroconductive base.

3. A method of manufacturing liquid-crystal cells, comprising the steps of:

   preparing a first transistor base comprising an electroconductive base formed of a conductor or semiconductor, a plurality of transistors formed on the electroconductive base with an insulating film provided therebetween, and a plurality of electrodes electrically connected to respective ones of the transistors;

   electrically connecting the electroconductive base to the electrodes;

   supplying electrostatic charge to the first transistor base with the electrodes connected;

   disconnecting the electrodes from the electroconductive base;

   preparing a second base;

   arranging the second base to face and be spaced from the first transistor base; and

   injecting a liquid crystal between the first and second bases.

4. A method of manufacturing liquid-crystal cells, comprising the steps of:

   preparing a base having a conductor or semiconductor, a plurality of transistors arranged in a plurality of columns and rows on the electroconductive base with an insulating film provided therebetween, and a common electrode which is electrically connected to the transistors and connected to a common terminal;

   electrically connecting the electroconductive base to the common electrode;

   supplying electrostatic charge to the first base in the connected condition.

   disconnecting the common electrode from the electroconductive base;

   preparing a second base;

   arranging the second base to face and be spaced from the first base; and

   injecting a liquid crystal between the first and second bases.

5. A method according to claim 1, wherein the electrodes are connected to the transistors through respective capacitors.

6. A method according to claim 2, wherein the common electrode is connected to the transistor through a capacitor.

7. A method according to claim 3, wherein the electrode is connected to the transistor through a capacitor.

8. A method according to claim 4, wherein the common electrode is connected to the transistors through a capacitor.

9. A method according to claims 1 or 3, wherein the connecting step comprises a step of electrically connecting the electroconductive base and the electrodes to the same electrical potential.

10. A method according to claims 2 or 4, wherein the connecting step comprises a step of electrically connecting the electroconductive base and the common electrode to the same electrical potential.

11. A method according to any preceding claim, wherein the step for supplying electrostatic charge includes a step of rubbing the base.

**12.** A method according to any preceding claim, wherein the step for supplying electrostatic charge includes a step of dicing the base.

**13.** A method according to any preceding claim, wherein the step for supplying electrostatic charge includes a step of cleaning the base.

**14.** A method according to any preceding claim, wherein the conductor or semiconductor is formed from single crystal silicon.

**15.** A method according to any preceding claim, wherein the or each transistor is of thin-film single crystal silicon.

**16.** A method of liquid crystal device manufacture which device comprises a semiconductor or conductor electroconductive base and one or more device electrodes, said method being characterised in that the base and said one or more device electrodes are clamped to a common potential during rubbing, dicing and cleaning operations.

# FIG. I

# FIG. 2

FIG. 3

GROUNDED AT
PREDETERMINED
ELECTRICAL
POTENTIAL

16a

17

3

2

1

16b

FIG. 4(a)

A – A'

16a  17

3

2

n⁺(p⁺)

1

16b

FIG. 4(b)

11

A

REPAIR AFTER
RUBBING

A'

17

3

# FIG. 5

REPAIR AFTER
RUBBING

A

A'

13

16a

# FIG. 6 (a)

DURING RUBBING (WAFER STATE)

16        14

# FIG. 6 (b)

AFTER DICING

14

# FIG. 7(a)

DURING RUBBING

7 3 7

SHORT-CIRCUIT

2

1

# FIG. 7(b)

10

7 7

INSULATION

2

1

CUT-OUT AREA
(FORMED INTO TRANSPARENT BASE)

# FIG. 8

OPENING

15 4 3

1

**European Patent Office**

**EUROPEAN SEARCH REPORT**

Application Number

EP    93 30 0571

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PATENT ABSTRACTS OF JAPAN vol. 14, no. 138 (P-1022)15 March 1990 & JP-A-20 03 012 ( TOSHIBA CORP ) * abstract * | 1-16 | G02F1/136 H01L27/12 |
| A | PATENT ABSTRACTS OF JAPAN vol. 13, no. 30 (P-816)24 January 1989 & JP-A-63 228 123 ( ALPS ELECTRIC CO LTD ) * abstract * | 1-16 | |
| A | PATENT ABSTRACTS OF JAPAN vol. 12, no. 499 (P-807)27 December 1988 & JP-A-63 208 023 ( ALPS ELECTRIC CO LTD ) * abstract * | 1-16 | |
| A | EP-A-0 376 165 (KABUSHIKI KAISHA TOSHIBA) * abstract * | 1-16 | |
| A | WO-A-8 902 095 (HUGHES AIRCRAFT COMPANY) * abstract * | 1-16 | |
| A | US-A-4 470 060 (YAMAZAKI) * column 12, line 33 - line 60; figures 20,21 * | 1-16 | TECHNICAL FIELDS SEARCHED (Int. Cl.5 ) G02F H01L |

The present search report has been drawn up for all claims

| Place of search | Date of completion of the search | Examiner |
|---|---|---|
| THE HAGUE | 15 APRIL 1993 | ONSHAGE A.C. |